# EUROPÄISCHE PATENTSCHRIFT

(11) **EP 3 192 139 B1**
(45) Veröffentlichungstag und Bekanntmachung des Hinweises auf die Patenterteilung: **09.09.2020**
(21) Anmeldenummer: 15733751.0
(22) Anmeldetag: 02.07.2015
(51) Int. Cl.: H02H 3/33, H02H 3/16, B60L 3/04, B60L 53/14, B60L 53/22, B60L 3/00

(54) **VERFAHREN UND VORRICHTUNG ZUM ERKENNEN EINES GLEICHSTROM-FEHLERSTROMS**
METHOD AND DEVICE FOR DETECTING A DIRECT-CURRENT FAULT CURRENT
PROCÉDÉ ET DISPOSITIF DE DÉTECTION D'UN COURANT DE COURT-CIRCUIT CONTINU

(30) Priorität: 08.09.2014 DE 102014217928
(43) Veröffentlichungstag der Anmeldung: 19.07.2017
(73) Patentinhaber: Robert Bosch GmbH, 70442 Stuttgart (DE)
(72) Erfinder: ECKERT, Bernd, 71665 Vaihingen an der Enz (DE); EPPLER, Steffen, 71642 Ludwigsburg (DE)
(86) Internationale Anmeldenummer: PCT/EP2015/065133
(87) Internationale Veröffentlichungsnummer: WO 2016/037721

(56) Entgegenhaltungen:
- DE-A1-102011 016 539
- DE-A1-102013 200 803

## Beschreibung

Die Erfindung betrifft ein Verfahren zum Erkennen eines Gleichstrom-Fehlerstroms in einem elektrischen Wechselstromkreis, wobei ein Verbraucher mit einer Gleichrichterstufe mit einer Primärseite an ein Wechselstromnetz angeschlossen ist und an einer Sekundärseite einen Gleichstrom bereitstellt und wobei das Wechselstromnetz mit einem Fehlerstromschutzschalter abgesichert ist. Die Erfindung betrifft des Weiteren ein Ladegerät umfassend eine Vorrichtung zum Erkennen eines Gleichstrom-Fehlerstroms in einem elektrischen Stromkreis.

### Stand der Technik

Die Stromnetze in Hausinstallationen oder für Stromabnahmestellen sind üblicherweise mit einer Überstromschutzeinrichtung gegen Überlast geschützt und umfassen des Weiteren eine Fehlerstrom-Schutzeinrichtung. Die Überstromschutzeinrichtung unterbricht den Stromfluss, wenn beispielsweise durch einen Kurzschluss eine Überlastung des Stromkreises auftritt. Üblicherweise sind in deutschen Haushalten die Stromkreise so abgesichert, dass die Überstromschutzeinrichtungen bei einem Strom oberhalb von 16 Ampere auslösen.

Die Fehlerstrom-Schutzeinrichtungen, häufig als Fehlerstromschutzschalter ausgeführt, unterbrechen den Stromfluss, wenn im Stromkreis ein Differenzstrom bzw. ein Fehlerstrom auftritt. Ein solcher Differenzstrom bzw. Fehlerstrom tritt auf, wenn im Stromkreis der zum Verbraucher hinfließende Strom nicht gleich groß ist wie der vom Verbraucher zurückfließende Strom. Ursache dafür kann ein Erdschluss sein, bei dem ein Teil des Stroms über die Erdung oder über einen Schutzleiter vom Verbraucher zurückfließt. Die Fehlerströme stellen eine Gefahr dar, da diese auf eine schadhafte Isolierung hindeuten, die bei Berührung eine Gefahr für Leib und Leben darstellt.

Als Fehlerstrom-Schutzeinrichtungen werden typischerweise Fehlerstromschutzschalter in verschiedenen Ausführungsformen eingesetzt. Dabei können Fehlerstromschutzschalter vom Typ AC lediglich rein sinusförmige Fehlerströme erkennen und im Fehlerfall die Stromleitung spannungsfrei schalten.

Fehlerstromschutzschalter vom Typ A können sowohl rein sinusförmige Fehlerströme als auch pulsierende Gleichstrom-Fehlerströme erkennen und im Fehlerfall die Stromleitung spannungsfrei schalten. Fehlerstromschutzschalter dieses Typs, die bei einem Fehlerstrom größer als 30 mA abschalten, werden üblicherweise in Deutschland für Hausinstallationen eingesetzt. Ist dem Wechselstrom ein Gleichstrom überlagert mit einer Stromstärke größer als ungefähr 6 mA, lösen Fehlerstromschutzschalter der Typen AC und A gar nicht mehr aus.

Des Weiteren sind Fehlerstromschutzschalter vom Typ B bekannt, die jedwede Art von Fehlerstrom erkennen können und damit auch bei einem reinen Gleichstrom-Fehlerstrom auslösen können. Für die Überwachung auf solche Gleichstrom-Fehlerströme ist jedoch eine Elektronikeinheit erforderlich, so dass Fehlerstromschutzschalter vom Typ B eine eigene Stromversorgung benötigen. Solche auch allstromsensitive Fehlerstromschutzschalter genannten Fehlerstrom-Schutzeinrichtungen sind im Stand der Technik bekannt, beispielsweise aus EP 0 866 536 A2.

Nachteilig an Fehlerstromschutzschaltern vom Typ B ist, dass diese im Vergleich zu Fehlerstromschutzschaltern vom Typ A aufwendig herzustellen und daher teuer sind. Der nächstliegende Stand der Technik DE 10 2013 200803 A1 offenbart ein Verfahren und eine Vorrichtung zum Erkennen eines Gleichstrom-Fehlerstroms in einem elektrischen Wechselstromkreis, wobei das Wechselstromnetz mit einem Fehlerstromschutzschalter abgesichert ist und wobei, wenn der Gleichstrom-Fehlerstrom über eine Auslöseschwelle liegt, einen den Fehlerstromgenerator ansprechenden Wechselfehlerstrom erzeugt wird.

### Offenbarung der Erfindung

Es wird ein Verfahren zum Erkennen eines Gleichstrom-Fehlerstroms nach Anspruch 1 vorgeschlagen.

Das Verfahren umfasst die Schritte:
a) Messen eines Gleichstrom-Fehlerstroms im Wechselstromkreis der Primärseite,
b) Vergleichen des Gleichstrom-Fehlerstroms mit einer vorgegebenen Gleichstrom-Auslöseschwelle und
c) Erzeugen eines Wechselstrom-Fehlerstroms, wenn der Gleichstrom-Fehlerstrom über der Auslöseschwelle liegt, wobei die Stromstärke des Wechselstrom-Fehlerstroms so gewählt ist, dass dieser über der Wechselstrom-Auslöseschwelle des Fehlerstrom-Schutzschalters liegt.

Bei dem Verfahren wird eine Gleichrichtereinheit mit einem Wechselstromnetz verbunden. Das Wechselstromnetz ist beispielsweise ein Stromkreis einer Hausinstallation oder eine Elektroinstallation für eine Stromabnahmestelle. Das Wechselstromnetz ist mit Schutzeinrichtungen versehen, die eine Überstromschutzeinrichtung gegen Überlast und einen Fehlerstromschutzschalter umfassen. Als Fehlerstromschutzschalter wird üblicherweise ein Fehlerstromschutzschalter vom Typ A eingesetzt, der sowohl sinusförmige Wechselstrom-Fehlerströme als auch pulsierende Gleichstrom-Fehlerströme erkennen kann, oder vom Typ AC, der nur sinusförmige Wechselstrom-Fehlerwechselströme, also nur Wechselstrom-Fehlerströme erkennen kann. Fehlerstromschutzschalter vom Typ A werden in Deutschland üblicherweise zur Absicherung von Hausinstallationen und Stromabnahmestellen eingesetzt. Diese Fehlerstromschutzschalter unterbrechen den Stromfluss im Stromkreis, wenn diese einen Wechselstrom-Fehlerstrom erkennen, der über einer Auslöseschwelle liegt. Mit der Unterbrechung des Stromflusses wird der Stromkreis spannungsfrei geschaltet. Bei Wechselstrom-Fehlerströmen liegt die Auslöseschwelle üblicherweise bei etwa 30 mA, so dass beim Vorliegen eines Wechselstrom-Fehlerstroms ≥ 30 mA der Stromfluss im Stromkreis unterbrochen wird. Dabei wird bei Wechselstromnetzen üblicherweise sowohl die Phase als auch der Neutralleiter unterbrochen. Lediglich der Schutzleiter ist von der Unterbrechung ausgenommen.

Im zweiten Schritt b) des Verfahrens wird der gemessene Gleichstrom-Fehlerstrom mit einer vorgegebenen Gleichstrom-Auslöseschwelle verglichen. Diese Gleichstrom-Auslöseschwelle kann bei dem Verfahren fest vorgegeben sein oder kann anpassbar ausgeführt sein, beispielsweise um das Verfahren an gesetzliche Anforderungen in verschiedenen Ländern anpassen zu können. Die Gleichstrom-Auslöseschwelle liegt beispielsweise zwischen 2 mA und 6 mA, bevorzugt zwischen 5 und 6 mA.

Liegt der gemessene Gleichstrom-Fehlerstrom über der vorgegebenen Gleichstrom-Auslöseschwelle, so wird gemäß Schritt c) des Verfahrens ein Wechselstrom-Fehlerstrom erzeugt, dessen Stromstärke so gewählt ist, dass dieser den Fehlerstromschutzschalter im Wechselstromnetz auslösen wird. Auf diese Weise wird erreicht, dass der Fehlerstromschutzschalter vom Typ A oder vom Typ AC, die von sich aus keinen Gleichstrom-Fehlerstrom erkennen können, auch bei Vorliegen eines Gleichstrom-Fehlerstroms auslösen. Durch die Begrenzung der Auslöseschwelle auf maximal 6 mA wird vermieden, dass der Magnetkreis von Fehlerstromschutzschaltern der Typen A und AC in Sättigung getrieben wird und somit einen Fehler nicht mehr erkennen kann.

Bei dem erfindungsgemäßen Verfahren wird der Wechselstrom-Fehlerstrom gemäß Schritt c) des Verfahrens durch das Zuschalten eines elektrischen Widerstands an der Primärseite der Gleichrichtereinheit erzeugt. Das Zuschalten erfolgt bevorzugt mit Hilfe eines elektrisch betätigbaren Schalters, beispielsweise mit Hilfe eines Relais oder mit Hilfe eines Halbleiterschalters. Über den elektrisch betätigbaren Schalter und den elektrischen Widerstand wird die nicht geerdete Phase des Wechselstromnetzes bzw. ein ersten Leiter bei nicht eindeutiger Polung mit dem Schutzleiter und damit mit der Erdung verbunden. Der elektrische Widerstand ist dabei so dimensioniert, dass der so erzeugte Fehlerstrom über der Wechselstrom-Auslöseschwelle des Fehlerstrom-Schutzschalters liegt. Ist die Polung im Wechselstromnetz nicht eindeutig definiert, z. B. bei Anschluss über eine gewöhnliche Steckdose, so kann im Anschluss überprüft werden, ob der Stromkreis erfolgreich spannungsfrei geschaltet wurde. Ist dies nicht der Fall, kann ein zweiter Leiter über einen elektrischen Widerstand und einen elektrisch betätigbaren Schalter mit dem Schutzleiter verbunden werden. Im Anschluss kann erneut überprüft werden, ob der Stromkreis spannungsfrei geschaltet wurde, wobei eine akustische und/oder optische Warnmeldung erfolgen kann, wenn keine Spannungsfreischaltung erreicht werden konnte.

Bei dem erfindungsgemäßen Verfahren wird der von der Gleichrichtereinheit bereitgestellte Gleichstrom zum Aufladen eines Energiespeichers verwendet und es wird ein Wechselstrom-Fehlerstrom als Abschaltsignal erzeugt, wenn der Energiespeicher vollständig geladen ist. Ein solcher Energiespeicher kann beispielsweise eine Batterie bzw. ein Akkumulator oder ein Kondensator sein. Der Energiespeicher kann dabei insbesondere einem elektrisch angetriebenen Fahrzeug, wie beispielsweise einem Hybridfahrzeug oder einem Elektroauto, zugeordnet sein.

Das Verfahren eignet sich insbesondere für Stromabnahmestellen, die sich außerhalb eines Gebäudes befinden und damit für jedermann zugänglich sind, wobei der Fehlerstromschutzschalter bevorzugt an einem unzugänglichen Ort angebracht ist. Dabei lässt sich die Stromabnahmestelle nach dem vollständigen Aufladen des Energiespeichers durch den Fehlerstromschutzschalter spannungsfrei schalten, so dass nach Abschluss des Ladevorgangs Unbefugte die Stromabnahmestelle nicht verwenden können. Erst nach Rücksetzen des Fehlerstromschutzschalters durch einen berechtigen Benutzer ist ein weiterer Ladevorgang möglich.

In einer weiteren Ausführungsform des Verfahrens wird die Funktionsfähigkeit des Fehlerstromschutzschalters überprüft, indem ein Wechselstrom-Fehlerstrom erzeugt wird. Dies kann insbesondere auf explizite Anweisung eines Benutzers geschehen, beispielsweise über das Vorsehen eines Testmodus an der Gleichrichtereinheit oder kann immer automatisch nach Abschluss eines Ladevorgangs von einem Energiespeicher ausgelöst werden.

In einer Ausführungsform des Verfahrens wird auf eine Fehlfunktion des Fehlerstromschutzschalters geschlossen, wenn nach Erzeugung des Wechselstrom-Fehlerstroms die Primärseite der Gleichrichtereinheit nicht spannungsfrei geschaltet wird. Dabei kann vorgesehen sein, dass ein Signal generiert wird, beispielsweise ein akustisches oder ein optisches Signal, um die Verwender der Gleichrichtereinheit vor der Fehlfunktion des Fehlerstromschutzschalters in Kenntnis zu setzen.

Ein weiterer Aspekt der Erfindung betrifft ein Ladegerät nach Anspruch 3. Das Ladegerät umfasst eine Vorrichtung zum Erkennen eines Gleichstrom-Fehlerstroms in einem elektrischen Stromkreis. Dabei ist die Vorrichtung bevorzugt zur Durchführung der hierin beschriebenen Verfahren ausgebildet und/oder eingerichtet. Dementsprechend gelten im Rahmen des Verfahrens beschriebene Merkmale entsprechend für die Vorrichtung und umgekehrt die im Rahmen der Vorrichtung beschriebenen Merkmale entsprechend für das Verfahren.

Die Vorrichtung umfasst eine Messeinheit zum Messen eines Gleichstrom-Fehlerstroms sowie eine Auslöseeinheit, die eingerichtet ist, bei Vorliegen eines Gleichstrom-Fehlerstroms, der größer ist als eine vorgegebene Gleichstrom-Auslöseschwelle, einen Wechselstrom-Fehlerstrom zu erzeugen.

Das Ladegerät kann beispielsweise zum Aufladen eines Energiespeichers in Form einer Batterie bzw. eines Akkumulators, der einem Elektrofahrzeug oder einem Hybridfahrzeug zugeordnet ist, verwendet werden.

Das Ladegerät ist eingerichtet, einen Wechselstrom-Fehlerstrom zu erzeugen, wenn der Energiespeicher vollständig aufgeladen wurde. Hierzu kann das Ladegerät die Auslöseeinheit der Vorrichtung zum Erkennen eines Gleichstrom-Fehlerstroms verwenden.

In einer weiteren Ausführungsform umfasst das Ladegerät des Weiteren eine Kompensationseinheit, die eingerichtet ist, einen kurzzeitigen Gleichstrom-Fehlerstrom zu kompensieren, indem ein weiterer Gleichstrom-Fehlerstrom mit identischer Stromstärke aber entgegengesetzter Stromrichtung erzeugt wird. Auf diese Weise können kurzfristig oder einmalig auftretende Gleichstrom-Fehlerströme beseitigt bzw. kompensiert werden, ohne dass es sofort zu einer Abschaltung kommen muss. Der Ladevorgang wird dadurch zuverlässiger ausgeführt.

### Vorteile der Erfindung

Mit dem erfindungsgemäßen Verfahren und der erfindungsgemäßen Vorrichtung wird ein in der Hausinstallation bzw. in der Installation der Stromabnahmestelle ohnehin vorgesehener bzw. bereits vorhandener Fehlerstromschutzschalter vom Typ A oder vom Typ AC in die Lage versetzt, auch Gleichstrom-Fehlerströme zu erkennen. Vorteilhafterweise sind dazu keinerlei Änderungen in der bestehenden Elektroinstallation erforderlich. Die erfindungsgemäße Vorrichtung bzw. das erfindungsgemäße Verfahren werden im Zusammenhang mit an die bestehende Elektroinstallation angeschlossenen Verbrauchern mit Gleichrichtern eingesetzt. Solche Gleichrichter werden beispielsweise als Teil von Ladevorrichtungen zum Aufladen von Energiespeichern von elektrisch angetriebenen Fahrzeugen eingesetzt. Dabei werden im Gegensatz zu Ladegeräten für Consumer-Elektronik, wie beispielsweise Mobiltelefone oder MP3-Player, große Gleichströme verwendet, so dass es auch bei geringfügigen Schäden an der elektrischen Isolation oder durch Fehler in den sogenannten aktiven Gleichrichterstufen zu vergleichsweise großen Gleichstrom-Fehlerströmen kommen kann. Diese Gleichstrom-Fehlerströme stellen nicht nur für sich genommen eine Gefahrenquelle dar, sondern können unter Umständen verhindern, dass im Stromnetz vorhandene Fehlerstromschutzschalter ihre Schutzwirkung verlieren.

Das Nachrüsten der bestehenden Stromnetze mit Fehlerstromschutzschaltern vom Typ B, die sowohl bei einem Wechselstrom-Fehlerstrom als auch bei einem Gleichstrom-Fehlerstrom auslösen können, ist jedoch vorteilhafterweise im Zusammenhang mit der vorliegenden Erfindung nicht mehr erforderlich, da die bestehenden Fehlerstromschutzschalter vom Typ A oder Typ AC in die Lage versetzt werden, auch bei Auftreten eines reinen Gleichstrom-Fehlerstroms auszulösen. Dazu ist erfindungsgemäß vorgesehen, dass an der Primärseite einer Gleichrichtereinheit eventuell auftretende Gleichstrom-Fehlerströme erkannt werden und bei Vorliegen eines Gleichstrom-Fehlerstroms ein Wechselstrom-Fehlerstrom erzeugt wird, der in der Lage ist, den Fehlerstromschutzschalter auszulösen.

Gegenüber der Möglichkeit, der Gleichrichtereinheit einen eigenen Fehlerstromschutzschalter vom Typ B zuzuordnen, ist die erfindungsgemäße Vorrichtung vergleichsweise einfach ausgeführt, da diese keine eigene Einrichtung benötigt, um den Stromfluss zu unterbrechen. Die Unterbrechung des Stromflusses wird durch den im Stromnetz bereits vorhandenen Fehlerstromschutzschalter ausgeführt.

Weiterhin wird die ordnungsgemäße Funktion des Fehlerstromschutzschalters regelmäßig durch die Nutzung zum Spannungsfreischalten der Steckdose überprüft.

Weiterhin kann mit bestimmungsgemäß ausgerüsteten Verbrauchern jede beliebige Steckdose als Energiequelle verwendet werden, ohne unbeabsichtigterweise Leib und Leben anderer Nutzer zu gefährden, die zufälligerweise und unwissentlich denselben Stromkreis benutzen.

### Kurze Beschreibung der Zeichnung

Die einzige Figur zeigt eine schematische Darstellung eines beispielhaften Ladegeräts mit einer beispielhaften Vorrichtung zum Erkennen eines Gleichstrom-Fehlerstroms. Nicht alle Merkmale der Erfindung sind in der Figur dargestellt.

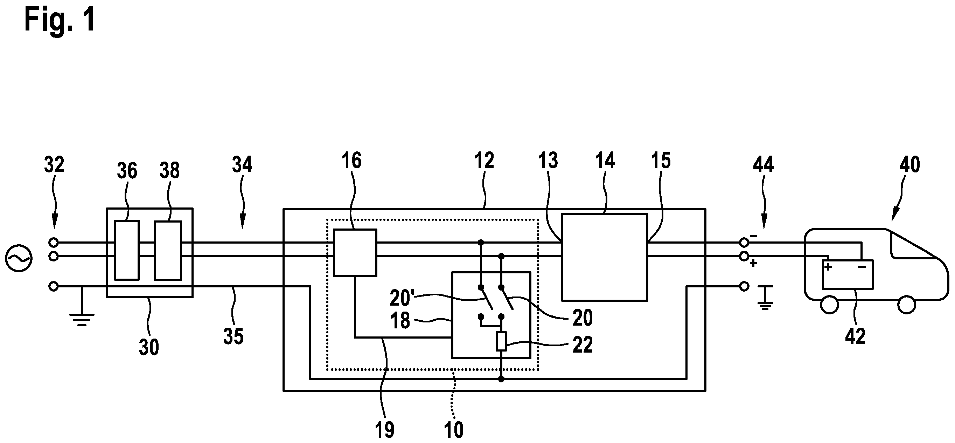

Figur 1 zeigt ein Ladegerät 12, welches eingerichtet ist, einen Energiespeicher 42 eines Fahrzeugs 40 aufzuladen. Das Ladegerät 12 ist dazu mit einem Wechselstromnetz 34 verbunden, welches über einen Sicherungskasten 30 an das öffentliche Stromnetz 32 angeschlossen ist. Bei dem Wechselstromnetz 34 kann es sich um einen Stromkreis eines Hausstromnetzes handeln. In dem Sicherungskasten 30 sind als Schutzvorrichtungen eine Überstromschutzeinrichtung 36 sowie ein Fehlerstromschutzschalter 38 aufgenommen.

Die Überstromschutzeinrichtung 36 ist eingerichtet, den Stromfluss im Wechselstromnetz 34 zu unterbrechen, wenn der Stromfluss im Wechselstromnetz 34 den zulässigen Wert übersteigt. In Deutschland werden die einzelnen Stromkreise des Wechselstromnetzes 34 im Falle eines Stromkreises eines Hausstromnetzes üblicherweise mit 16 Ampere abgesichert, d.h. in diesem Fall würde die Überstromschutzeinrichtung 36 auslösen, wenn der Stromfluss im Wechselstromnetz 34 16 Ampere übersteigt. Der Fehlerstromschutzschalter 38 ist beispielsweise als Fehlerstromschutzschalter vom Typ A ausgeführt, wie er üblicherweise in Deutschland für Hausinstallationen verwendet wird. Der Fehlerstromschutzschalter 38 erkennt sinusförmige, also Wechselstrom-Fehlerströme sowie pulsförmige Gleichstrom-Fehlerströme. Wird ein Fehlerstrom, insbesondere ein Wechselstrom-Fehlerstrom, mit einer Stromstärke ermittelt, die über der Wechselstrom-Auslöseschwelle liegt, so schaltet der Fehlerstromschutzschalter 38 das Wechselstromnetz 34 spannungsfrei. Bei den üblicherweise eingesetzten Fehlerstromschutzschaltern liegt die Wechselstrom-Auslöseschwelle bei etwa 30 mA. Dabei werden sowohl der Neutralleiter als auch die Phase getrennt. Der Schutzleiter bzw. Erdleiter wird dabei nicht getrennt.

Sowohl die Überstromschutzeinrichtung 36 als auch der Fehlerstromschutzschalter 38 sind dabei so eingerichtet, dass diese von einem Benutzer nach Beseitigung des Fehlers zurückgesetzt bzw. wieder eingeschaltet werden können.

Das Ladegerät 12 umfasst eine Gleichrichtereinheit 14, der eine Primärseite 13 und eine Sekundärseite 15 aufweist. Die Gleichrichtereinheit 14 ist mit seiner Primärseite 13 mit dem Wechselstromnetz 34 verbunden und die Sekundärseite 15 ist in der in Figur 1 dargestellten Situation über ein Ladekabel 44 mit dem Energiespeicher 42 des Fahrzeugs 40 verbunden.

Des Weiteren befindet sich an der Primärseite 13 der Gleichrichtereinheit 14 eine Messeinheit 16, die eingerichtet ist, einen Gleichstrom-Fehlerstrom zu ermitteln. Dazu misst die Messeinheit 16 die Stromstärke des Gleichstromanteils des fließenden Wechselstroms an der Primärseite 13 der Gleichrichtereinheit 14. Da im Normalfall der Wechselstrom keinen Gleichstromanteil aufweist, kann beim Vorliegen eines Gleichstromanteils auf das Vorliegen eines Fehlers geschlossen werden.

Die Messeinheit 16 vergleicht den gemessenen Gleichstrom-Fehlerstrom mit einer vorgegebenen Gleichstrom-Auslöseschwelle. Ist der gemessene Gleichstrom-Fehlerstrom größer oder gleich der Gleichstrom-Auslöseschwelle, wird durch die Messeinheit 16 eine Auslöseeinheit 18 aktiviert. Dazu ist die Auslöseeinheit 18 mit der Messeinheit 16 über eine Leitung 19 verbunden. Die Gleichstrom-Auslöseschwelle liegt beispielsweise bei 6 mA.

Die Auslöseeinheit 18 umfasst zwei elektrisch betätigbare Schalter 20 und 20' sowie einen ohmschen Widerstand 22. Die Auslöseeinheit 18 ist an einer Seite mit einem der stromführenden Leiter des Wechselstromnetzes 34 und auf der anderen Seite mit einem Schutzleiter 35 verbunden. Da handelsübliche Steckvorrichtungen ohne Vorzugsrichtung gesteckt werden können, ist die Auslöseeinheit (18) zweipolig ausgeführt, so dass nacheinander die beiden elektrisch betätigbaren Schalter 20, 20' zur Erzeugung eines Auslösefehlerstroms geschaltet werden können. Ist die Polung eindeutig vorgegeben ist hingegen ein einziger elektrisch betätigbarer Schalter 20 ausreichend, der mit dem als Phase bezeichneten Leiter des Wechselstromnetzes 34 verbunden ist.

Wird die Auslöseeinheit 18 aktiviert, so wird der elektrisch betätigbare Schalter 20 geschlossen, so dass Strom aus dem Wechselstromnetz 34 über den Widerstand 22 in den Schutzleiter 35 fließt. Dabei ist der Widerstand 22 von seiner Größe so dimensioniert, dass der nach Schließen des elektrisch betätigbaren Schalters 20 fließende Wechselstrom, der einen Wechselstrom-Fehlerstrom darstellt, größer ist, als die Wechselstrom-Auslöseschwelle des Fehlerstromschutzschalters 38. Bei einer Spannung von 230 V im Wechselstromnetz 34 beträgt der Widerstand 22 beispielsweise 6 kΩ, um einen Wechselstrom-Fehlerstrom von etwa 38 mA zu erzeugen. Wird von der Messeinheit 16 kein Wechselstrom-Fehlerstrom nach der Betätigung von Schalter 20 erkannt, wird dieser wieder geöffnet und der andere Schalter 20' geschlossen.

Die Auslöseeinheit 18 und die Messeinheit 16 bilden zusammen die Vorrichtung 10 zum Erkennen eines Gleichstrom-Fehlerstroms. Durch das Vorsehen dieser Vorrichtung 10 wird der Fehlerstromschutzschalter 38, der alleine keinen Gleichstrom-Fehlerstrom kennen kann, in die Lage versetzt, bei Auftreten eines Gleichstrom-Fehlerstroms an der Primärseite 13 der Gleichrichtereinheit 14 auszulösen. Somit wird auch ohne ein Austauschen des Fehlerstromschutzschalters 38 gegen einen sogenannten allstromsensitiven Fehlerstromschutzschalter bzw. Fehlerstromschutzschalter vom Typ B ein umfassender Schutz gegen Fehlerströme erreicht.

Neben der beschrieben beispielhaften Verwendung der Vorrichtung 10 mit einem Ladegerät 12 ist auch eine Verwendung der Vorrichtung 10 im Zusammenhang mit anderen Geräten oder Maschinen denkbar, die mit geschalteten Gleichrichtern oder mit Gleichstromzwischenkreisen arbeiten. Dies umfasst beispielsweise Geräte und Maschinen mit sogenannten Frequenzumrichtersteuerungen wie Waschmaschinen und Aufzüge sowie alle elektrischen Verbraucher, die aus Wechselstrom Gleichstrom erzeugen und keine geeignete, primärseitige galvanische Trennung aufweisen

Die Erfindung ist nicht auf die hier beschriebenen Ausführungsbeispiele und die darin hervorgehobenen Aspekte beschränkt. Vielmehr sind innerhalb des durch die Ansprüche angegebenen Bereichs eine Vielzahl von Abwandlungen möglich, die im Rahmen fachmännischen Handelns liegen.

## Patentansprüche

1. Verfahren zum Erkennen eines Gleichstrom-Fehlerstroms in einem elektrischen Wechselstromkreis, wobei eine Gleichrichtereinheit (14) mit einer Primärseite (13) an ein Wechselstromnetz (34) angeschlossen ist und an einer Sekundärseite (15) einen Gleichstrom bereitstellt und wobei das Wechselstromnetz (34) mit einem Fehlerstromschutzschalter (38) abgesichert ist, der den Stromkreis unterbricht, wenn ein Wechselstrom-Fehlerstrom größer als eine vorgegebene Wechselstrom-Auslöseschwelle auftritt, umfassend die Schritte:
a) Messen eines Gleichstrom-Fehlerstroms an der Primärseite (13),
b) Vergleichen des Gleichstrom-Fehlerstroms mit einer vorgegebenen Gleichstrom-Auslöseschwelle und
c) Erzeugen eines Wechselstrom-Fehlerstroms, wenn der Gleichstrom-Fehlerstrom über der Auslöseschwelle liegt, wobei die Stromstärke des Wechselstrom-Fehlerstroms so gewählt ist, dass dieser über der Wechselstrom-Auslöseschwelle des Fehlerstrom-Schutzschalters liegt und dass der Wechselstrom-Fehlerstrom durch das Zuschalten eines Widerstands (22) an der Primärseite (13) erzeugt wird,
**dadurch gekennzeichnet, dass** der Gleichstrom als Ladestrom zum Aufladen eines Energiespeichers (42) verwendet wird und ein Wechselstrom-Fehlerstrom auch dann erzeugt wird, wenn der Energiespeicher (42) vollständig geladen ist.

2. Verfahren nach Anspruch 1, **dadurch gekennzeichnet, dass** auf eine Fehlfunktion des Fehlerstromschutzschalters (38) geschlossen wird, wenn nach Erzeugung des Wechselstrom-Fehlerstroms die Primärseite (13) nicht spannungsfrei geschaltet wird.

3. Ladegerät (12) zur Ausführung des Verfahrens nach den vorhergehenden Ansprüchen, wobei das Ladegerät eine Vorrichtung (10) zum Erkennen eines Gleichstrom-Fehlerstroms in einem elektrischen Stromkreis umfasst, die Vorrichtung (10) umfassend eine Messeinheit (16) zum Messen eines Gleichstrom-Fehlerstroms und eine Auslöseeinheit (18), die eingerichtet ist, bei Vorliegen eines Gleichstrom-Fehlerstroms, der größer ist als eine vorgegebene Gleichstrom-Auslöseschwelle, einen Wechselstrom-Fehlerstrom zu erzeugen, **dadurch gekennzeichnet, dass** das Ladegerät (12) eingerichtet ist, einen Wechselstrom-Fehlerstrom auch dann zu erzeugen, wenn der Energiespeicher (42) vollständig aufgeladen wurde.

4. Ladegerät (12) nach Anspruch 3, **dadurch gekennzeichnet, dass** das Ladegerät (12) eine Kompensationseinrichtung umfasst, die eingerichtet ist, einen kurzzeitigen Gleichstrom-Fehlerstrom zu kompensieren durch Erzeugen eines weiteren Gleichstrom-Fehlerstroms mit identischer Stromstärke aber entgegengesetzter Stromrichtung.

## Claims

1. Method for detecting a DC fault current in an electrical AC circuit, wherein a rectifier unit (14) is connected to an AC grid (34) at a primary side (13) and provides a DC current at a secondary side (15), and wherein the AC grid (34) is secured by a fault current protection switch (38) that interrupts the circuit when an AC fault current greater than a predefined AC trip threshold occurs, comprising the steps of:
a) measuring an DC fault current at the primary side (13),
b) comparing the DC fault current with a predefined DC trip threshold, and
c) generating an AC fault current when the DC fault current is above the trip threshold, wherein the current strength of the AC fault current is selected such that it is above the AC trip threshold of the fault current protection switch and that the AC fault current is generated by connecting in a resistor (22) at the primary side (13),
**characterized in that** the DC current is used as charging current for charging an energy store (42) and an AC fault current is generated even if the energy store (42) is fully charged.

2. Method according to Claim 1, **characterized in that** a malfunction of the fault current protection switch (38) is inferred if the primary side (13) is not switched in a voltage-free manner after the AC fault current has been generated.

3. Charger (12) for performing the method according to either of the preceding claims, wherein the charger has a device (10) for detecting a DC fault current in an electrical circuit, the device (10) comprising a measurement unit (16) for measuring a DC fault current and a trip unit (18) that is configured so as to generate an AC fault current in the presence of a DC fault current that is greater than a predefined DC trip threshold, **characterized in that** the charger (12) is configured so as to generate an AC fault current even when the energy store (42) has been fully charged.

4. Charger (12) according to Claim 3, **characterized in that** the charger (12) comprises a compensation apparatus that is configured so as to compensate a brief DC fault current by generating a further DC fault current with an identical current strength but an opposing current direction.

## Revendications

1. Procédé de détection d'un courant de court-circuit continu dans un circuit électrique à courant alternatif, dans lequel une unité de redressement (14) est connectée à un réseau de courant alternatif (34) par un côté primaire (13) et fournit un courant continu sur un côté secondaire (15), et dans lequel le réseau de courant alternatif (34) est protégé par un interrupteur de protection contre les courants de court-circuit (38) qui coupe le circuit électrique si un courant de court-circuit alternatif survient qui est supérieur à un seuil de déclenchement de courant alternatif spécifié, comprenant les étapes consistant à :
a) mesurer un courant de court-circuit continu du côté primaire (13),
b) comparer le courant de court-circuit continu à un seuil de déclenchement de courant continu spécifié, et
c) produire un courant de court-circuit alternatif si le courant de court-circuit continu dépasse le seuil de déclenchement, l'intensité de courant du courant de court-circuit alternatif étant sélectionnée de telle sorte que celui-ci dépasse le seuil de déclenchement de courant alternatif de l'interrupteur de protection contre les courants de court-circuit et que le courant de court-circuit alternatif soit produit par la mise en circuit d'une résistance (22) du côté primaire (13),
**caractérisé en ce que** le courant continu est utilisé comme un courant de charge pour recharger un accumulateur d'énergie (42) et un courant de court-circuit alternatif (42) est produit même si l'accumulateur d'énergie est complètement chargé.

2. Procédé selon la revendication 1, **caractérisé en ce qu'**on conclut à un dysfonctionnement de l'interrupteur de protection contre le courant de court-circuit (38) si le côté primaire (13) n'est pas mis hors tension après la production du courant de court-circuit alternatif.

3. Chargeur (12) permettant d'exécuter le procédé selon l'une quelconque des revendications précédentes, le chargeur comprenant un dispositif (10) de détection d'un courant de court-circuit continu dans un circuit électrique à courant alternatif, le dispositif (10) comprenant une unité de mesure (16) pour mesurer un courant de court-circuit continu et une unité de déclenchement (18) qui est aménagée pour produire un courant de court-circuit alternatif en présence d'un courant de court-circuit continu qui est supérieur à un seuil de déclenchement de courant continu spécifié, **caractérisé en ce que** le chargeur (12) est aménagé pour produire un courant de court-circuit alternatif même si l'accumulateur d'énergie (42) a été complètement chargé.

4. Chargeur (12) selon la revendication 3, **caractérisé en ce que** le chargeur (12) comprend un dispositif de compensation qui est aménagé pour compenser un courant de court-circuit continu bref en produisant un courant de court-circuit continu supplémentaire d'intensité de courant identique mais de sens de courant opposé.
